# EUROPEAN PATENT APPLICATION

(11) **EP 1 930 955 A2**
(43) Date of publication of application: **11.06.2008**
(21) Application number: 07254755.7
(22) Date of filing: 07.12.2007
(51) Int. Cl.: H01L 31/18, H01L 31/048

(54) **Process and device to produce a solar panel with enhanced light capture**

(30) Priority: 08.12.2006 US 873861 P
(71) Applicant: E.I. du Pont de Nemours and Company, Wilmington, DE 19898 (US)
(72) Inventor: Cheng, Lap Kin, Bear, Delaware 19701 (US); Rodriguez-Parada, Jose Manuel, Hockessin, Delaware 19707-2065 (US)
(74) Representative: Matthews, Derek Peter

(57) **Abstract**

The present invention is directed to a process for producing solar panels having an antireflective film designed to capture more incident light. The film increases the transmission of light through the film and a substrate by reducing the amount of light reflected and by minimizing optical loss in the film and at the interfaces. By allowing more incident light to transmit to the underlying solar cells, the solar panel can produce more electricity, thereby operating at a higher efficiency. The process uses lamination, particularly thermal lamination, to apply a light capturing film onto the front surface of a solar panel. The tight capturing film comprises of a cross-linked fluoropolymer antireflective coating on top of an optically clear carrier film.

## Description

### FIELD OF THE INVENTION

The present invention is directed to a process and a device for producing a solar panel having a film designed to transmit more incident light to a solar cell.

### BACKGROUND

Efficiency of conversion of incident light into electricity is a critical aspect of the design any solar power system. To protect fragile solar cells in these systems from the environment, and to electrically isolate the solar cells from human contact, solar cells are invariably encapsulated beneath protective layers such as glass and/or plastic sheets. In this case, light must be transmitted through the layer or layers to reach the solar cells. Depending on the material used, approximately 4-5% of the solar radiation incident on the protective layer is specularly reflected and lost. In addition to wasting potentially useful electrical energy, this specularly reflected light could create unwanted glare to the eyes. Reducing or eliminating this specular reflection creates the opportunity for higher energy conversion efficiency if the reflected light can be effectively redirected through the protective layer and onto the solar cells.

Nomura (US6384318) discloses a solar battery module effectively preventing public nuisance caused by reflection of light and a method of manufacturing the solar battery module

In contrast, the present invention uses lamination of a 75 to 150 nanometer thick fluoropolymer layer or layers on an ethylene copolymer carrier film. The lamination process allows an approximately quarter wavelength (75 to 150 nanometer) thick fluoropolymer layer or layers to be placed on a large area substrate without destroying its light capturing capability.

### SUMMARY OF THE INVENTION

One aspect of the present invention is a process comprising
a) providing a substrate comprising a front surface and a back surface;
b) laminating on the front surface a film comprising at least one cross-linked fluoropolymer layer or layers wherein the fluoropolymer layer or layers have a thickness between 75 and 150 nanometers and the fluoropolymer layer or layers are positioned on a carrier of an ethylene copolymer such that the ethylene copolymer carrier is in contact with the substrate; and
a) attaching at least one solar cell to the back surface of the substrate.

Another embodiment of the present invention is a device comprising:
a) a mounting layer comprising:
   i) a substrate comprising a front surface and a back surface;
   ii) a film laminated to the front surface of the substrate
      wherein the film comprises at least one cross-linked fluoropolymer layer or layers having a thickness between 75 and 150 nanometers positioned on a carrier of an ethylene copolymer such that the ethylene copolymer is in contact with the substrate; and
b) at least one solar cell attached to the back surface of the substrate.

A further embodiment is a device comprising:
a) at least one solar cell comprising a front surface;
b) a film laminated to the front surface of the solar cell
   wherein the film comprises at least one cross-linked fluoropolymer layer or layers having a thickness between 75 and 150 nanometers positioned on a carrier of an ethylene copolymer such that the ethylene copolymer is in contact with the solar cell.

### BRIEF DESCRIPTION OF THE DRAWINGS

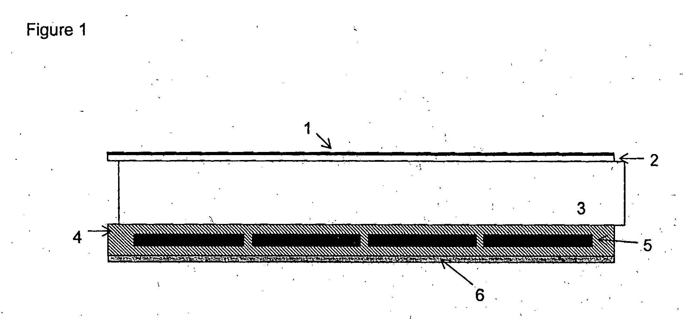

Figure 1 is an illustration of an antireflective film and solar cell positioned on a substrate.

### DETAILED DESCRIPTION

The invention is directed to a process and a device for producing a solar panel wherein the solar panel has a film designed to transmit more incident light to solar cells found within the panel. The film increases the transmission of light through the film and a substrate by reducing the amount of light reflected and by minimizing optical loss in the film and at the interfaces. By allowing more incident light to transmit to the underlying solar cells, the solar panel can produce more electricity, thereby operating at a higher efficiency. The process uses lamination, particularly thermal lamination, to apply a light capturing film onto the front surface of a solar panel. The light capturing film is comprised of a cross-linked fluoropolymer antireflective coating on top of an optically clear carrier film.

For antireflective films and coatings, it is desirable to have a coating of a thickness of one quarter of the wavelength of the incident radiation where the wavelength of the incident radiation is measured in the coating material and the index of refraction of the coating material is less than the index of the substrate.

For efficient capture of incident light with a broad spectrum, the wavelength should be selected to maximize the number of photons captured. For sunlight on Earth, this wavelength should be centered between 600-700 nm. This implies that a coating thickness of 75 to 150 nanometers is desired. Alternatively, this wavelength can be selected based on the spectral sensitivity of the solar cells. It is further desired that the index of refraction of the antireflection coating be lower than the substrate on which it is deposited.

Fluoropolymers exhibit very low indices of refraction. Furthermore, they have adequate mechanical properties to be fabricated into thin films, and their anti-soiling property help maintain high light transmission. For the process of the present invention, a fluoropolymer coating is deposited on a carrier forming a film. The carrier may be a film of ethylene copolymer, such as SURLYN^{®} (DuPont, Wilmington, DE). The carrier serves to support the thin fluoropolymer coating and adheres it to the substrate. The carrier is typically 25 to 500 microns thick and has an index of refraction in the range of 1.45 to 1.65, preferably between 1.45-1.55.

The fluoropolymer used as the coating on the carrier may preferably be Viton^{®} GF-200S fluoroelastomer (Dupont, Wilmington, DE) but may also be any fluoropolymer that can be dissolved in common solvents used for the deposition of thin films that has good adhesion to the carrier film, and that can be easily cross-linked. Fluoroelastomers suitable for use as the anti-reflective coating include fluoroelastomers comprising copolymerized units of one or more monomers containing fluorine, such as vinylidene fluoride, hexafluoropropylene; 1 -hydropentafluoropropylene, 2-hydropentafluoropropylene, tetrafluoroethylene, chlorotrifluoroethylerie, and perfluoro(alkyl vinyl ether), as well as other monomers not containing fluorine, such as ethylene, and propylene. Elastomers of this type are described in Logothetis, Chemistry of Fluorocarbon Elastomers, Prog. Polym. Sci., Vol. 14, 251-296 (1989). Specific examples of such fluoroelastomers include, but are not limited to copolymers of vinylidene fluoride and hexafluoropropylene and, optionally, tetrafluoroethylene; copolymers of vinylidene fluoride, hexafluoropropylene, tetrafluoroethylene and chlorotrifluoroethylene; copolymers of vinylidene fluoride and a perfluoro(alkyl vinyl ether) and, optionally, tetrafluoroethylene; copolymers of tetrafluoroethylene and propylene and, optionally, vinylidene fluoride; and copolymers of tetrafluoroethylene and perfluoro(alkyl vinyl ether), preferably perfluoro(methyl vinyl ether). Each of the fluoroelastomers comprises at least one halogenated cure site or a reactive double bond resulting from the presence of a copolymerized unit of a non-conjugated diene. The halogenated cure sites may be copolymerized cure site monomers or halogen atoms that are present at terminal positions of the fluoroelastomer polymer chains. The cure site monomers, reactive double bonds or halogenated end groups are capable of reacting to form cross-links.

The anti-reflective coating can further comprise a multiolefinic cross-linking agent containing at least two non-conjugated carbon-carbon double bonds. Typically, the cross-linking agent is present in an amount of 1 to 25 parts by weight per 100 parts by weight elastomer (parts per hundred). Preferably, the cross-linking agent is present at a level between 1 and 10 phr. The cross-linking agent has a general formula R(OC(O)CR'=CH₂)ₙ where R is linear or branched alkyl, or linear or branched alkyl ether, or aromatic, or aromatic ether, or heterocyclic; arid wherein R' is H, or CH₃; and wherein n is an integer from 2 to 8. Preferably, the non-fluorinated multiolefinic cross-linking agent has the general formula R(CH₂CR'=CH₂)ₙ where R is linear or branched alkyl, or linear or branched alkyl ether, or aromatic, or aromatic ether, or aromatic ester, or heterocyclic; and wherein R' is H, or CH₃; and wherein n is an integer from 2 to 6.

The compositions of the present invention can be cured via a free radical mechanism. Free radicals may be generated by several different means such as by the thermal decomposition of an organic peroxide optionally contained in the compositions of this invention, or by radiation such as ultraviolet (UV) radiation, gamma radiation, or electron beam radiation.

When UV radiation initiation used, the anti-reflective coatings of the invention may also include a photo-initiator. Anti-reflective coatings of the invention that contain a photoinitiator typically contain between 1 and 10 parts per hundred, preferably between 5 and 10 parts per hundred. Examples of photoinitators include but are not limited to Irgacure^{®}-651 (Ciba Specialty Chemicals, Basel, Switzerland), Irgacure^{®}-184, and Irgacure^{®}-907. In addition, the photoinitiators may be used singly or in combinations of two or more types.

Anti-reflective coatings of the invention which contain an organic peroxide typically contain between 1 and 10 parts per hundred, preferably between 5 and 10 parts per hundred. Examples of organic peroxides which may be employed in the compositions of the invention include, but are not limited to 1,1-bis(t-butylperoxy)-3,5,5-trimethylcyclohexane; 1,1bis(t-butylperoxy)cyclohexane; 2,2-bis(t-butylperoxy)octane; n-butyl-4, 4-bis(t-butylperoxy)valerate; 2,2-bis(t-butylperoxy)butane; 2,5-dimethylhexane-2,5-dihydroxyperoxide; di-t-7butyl, peroxide; t-butylcumyl peroxide; dicumyl peroxide; alpha, alpha'-bis(t-butylperoxy-m-isopropyl)benzene; 2,5-dimethyl-2,5-di(t-butylperoxy)hexane; 2,5-dimethyl-2,5-di(t-butylperoxy)hexene-3; benzoyl peroxide, t-butylperoxybenzene; 2,5-dimethyl-2,5-di(benzoylperoxy)-hexane; t-butylperoXymaleic acid; and t-butylperoxyisopropylcarbonate. A preferred example of an organic peroxide is benzoyl peroxide. In addition, the organic peroxides may be used singly or in combinations of two or more types, as well as in combination with photoinitators as described above.

The fluoropolymer coating can be deposited on the ethylene copolymer carrier by a number of standard coating processes capable of precise thickness control. These include micro-gravure printing, and dip coating. Of these, micro-gravure printing is the most preferred.

After deposition of the fluoropolymer layer or layers on the carrier to form the antireflective film, the film is laminated on a substrate. Multiple layers of fluoropolymer may be deposited on the carrier. However, the total thickness of the fluoropolymer layer or layers is between 75 and 150 nanometers. The substrate is essentially transparent to visible and near infrared light. The substrate may be glass, polymethylmethacrylate, polyester, polycarbonate or polysiloxane. Lamination is a process where two objects are adhered together under the influence of pressure and heat. In the process of the present invention, the two objects are the substrate and the coating comprising the fluoropolymer and the ethylene copolymer film. During lamination, the antireflective film should be positioned such that the ethylene copolymer film layer is in contact with the substrate. Lamination may be performed under a range of pressures and temperatures to obtain good adhesion to the substrate. During lamination, it is particularly important that the optical transmission of the combined objects does not degrade. To ensure an optical coupling of these two objects, the bottom surface of the ethylene copolymer may be roughened to permit egress of trapped air. The lamination of the antireflective film on a substrate allows the very thin (75 t0 150 nanometers) antireflective film, with uniform thickness required, to be attached to the substrate while minimizing the introduction of optical defects such as tears, pores and cracks into this very thin antireflection film. Such defects would reduce the amount of light transmitted through the film and substrate, and are highly undesirable.

After the lamination stage of the process, the antireflective film is adhered to the substrate. A measure of the effectiveness of the antireflection film is the light gain. If the intensity of light transmitted through a bare substrate is compared with the light transmitted through a substrate laminated with the antireflective film, an increase in intensity of up to 2.5% can be measured. The mounting layer (for the solar cell) is defined as the substrate, the carrier and the fluoropolymer layer is defined as the antireflective film.

ASTM E424 defines solar transmission gain for layers. Under this standard, a solar transmission gain, ΔTₛₒₗ, is defined as the difference in transmission of solar radiation before and after the addition of coating layers such as the lamination of the antireflective film on the substrate. A light gain between 1.5-2.5% can be expected through the mounting layer as compared to a bare substrate.

In the next step of the process of the present invention, at least one solar cell is attached to the back side (opposite the antireflection film) of the substrate. A solar cell is a well-known device to convert light into electrical energy and is described in numerous textbooks. A particularly detailed discussion of the different types of solar cells can be found in, for example, A. Luque and S. Hegedus, Handbook of Photovoltaic Science and Engineering, published by John Wiley & Sons, Ltd., 2003. Solar cells can be attached to the substrate using a variety of transparent glues, thermoplastic, and thermosetting compounds. In some cases such as thin film solar modules, solar cells can be deposited directly onto the backside of the above mentioned substrate.

Specifically, discrete crystalline silicon solar cells are typically assembled into solar modules using a lamination process. In this process, strings of electrically connected solar cells are placed between transparent glue layers, which are then sandwiched between a top cover (i.e. the aforementioned substrate of this invention) and a polymeric back sheet (e.g. Tedlar^{®}). This whole stack is then placed in a vacuum laminator and brought to a prescribed temperature, typically 100-175ºC, preferably 140-150ºC, to achieve curing of the glue layers, thereby fixing the solar cells in place and adhering them to the top cover. An example of a vacuum laminator suitable for this process is the SPI-Laminator 460 manufactured by Spire Corp. (Bedford, Massachusetts). The process of the present invention including the introduction of an antireflective layer on a carrier film can be seamlessly integrated into the module manufacturing process described above.

Thin film solar cells, specifically those fabricated onto flexible foils such as a stainless steel sheet or polymeric sheet can use a different module assembly scheme. In these cases, solar cells can be fabricated continuously or semi-continuously using a roll-to-roll coating or deposition process. For these flexible solar modules, a continuous light capturing film, can be unwound from a roller and inserted as an additional top layer prior to feeding through the nips of the hot rollers of the laminator. Furthermore, it is also possible that the light capturing film of the invention may replace the top cover sheet used in these flexible thin film solar modules altogether.

Furthermore, the light capturing laminate of this invention does not have to be applied during module fabrication. It is expected that the laminate can be applied directly onto finished modules, which would include modules that are already installed as part of a functioning solar energy system. The application of our laminate can enhance the energy conversion efficiency, and the economic value of these installed systems.

The use of antireflective coatings to reduce glare is not new. Specifically, antireflective coatings have been widely used in many optical applications, such as eyeglasses, laser optics, and computer displays. However, these applications have different performance requirements, which invariably result in different designs. For instance, for laser optics such as beam splitters or laser mirrors, transmission of >99.95% is sometimes required at specific, monochromatic wavelength to suppress unwanted signal or laser oscillation.

Similarly, for computer or TV displays, a broader spectral response (from 420-700 nm, commensurate with human visual responses) with low %Rᵥᵢₛ is needed to reduce ghost image reflection that interferes with the clarity of displayed images.

In solar panel applications aimed at enhancing light capture, one obvious requirement for any light capturing film is that the percent total transmission of solar radiation across a very broad spectrum is higher in the presence of the antireflective coating than without it. The spectral range in which enhanced light transmission is desirable depends on the underlying photovoltaic technology (e.g. from 380-1120 nm for crystalline silicon solar modules; 400-825 nm for CdTe solar cells, 380-950 nm for triple-junction amorphous silicon solar cells, 380-1150 nm for microcrystalline silicon solar cells, and 400-1240 nm for Cu(InₓGa_{y})Se₂ solar cells...etc.), but typically covers a broad region from near ultraviolet to near infrared. Such coating should additionally be stable with respect to outdoor environmental exposures.

While commercial antireflective laminates exist for use in LCD displays, these laminates are generally designed for antiglare, and to provide maximum scratch resistance and for indoor use. As a result, these LCD laminates generally possess minimal light capturing capability (i.e. little or no overall increase in percent transmission) and are constructed with materials that readily degrade under prolonged outdoor exposures (e.g. polyester, PET) or lack the high temperature stability needed to withstand thermal processing (e.g. during module lamination).

A common practice to achieve antiglare is to roughen the optically smooth surface of the substrate thereby destroying the coherence of the reflected light. This roughening is often implemented by "matting" or by introducing scattering centers. These approaches, however, introduce additional optical losses that degrade light transmission.

To achieve meaningful light capture, it is therefore important to use materials that have suitable optical clarity such that the anti-reflected light can easily transmit through the layers and the cover sheet (e.g. glass) and fall onto the solar cells. Additionally, these materials need to interact favorably with each other and with the cover sheet (e.g. glass) to form low loss interfaces, thereby enabling the desired transmission gain. Optionally, UV filtering additives and antioxidants can be added to the fluoropolymer coating, and to the carrier and adhesive layers to improve the durability of the light capturing laminate. Examples of effective additives would include UV absorbers such as benzotriazoles and benzophenones, UV stabilizers such as hindered amines, and antioxidants such as various phenolic compounds.

An embodiment of a device made in accordance to the invention is illustrated in Figure 1. The figure illustrates an antireflective film and a solar cell positioned on a substrate. More particularly, as shown in Figure 1, the embodiment includes;

| | |
|---|---|
| 1. | Fluoropolymer coating^{*} |
| 2. | Ethylene copolymer carrier^{*} |
| 3. | Substrate, such as glass |
| 4. | Glue layers, such as cross-linked ethylene vinyl acetate |
| 5. | Solar cells |
| 6. | Back sheet, such as Tedlar^{®} |

| | |
|---|---|
| ^{*}One embodiment of the film of the invention comprises the flouropolymer coating (1) and the ethylene copolymer carrier (2). | |

### EXAMPLES

### Comparative Example 1.

Formulation **A** was prepared by dissolving 4.5 g Viton^{®} GF-200S fluoroelastomer (DuPont), 0.45 g benzoyl peroxide (Aldrich) and 0.45 g triallyl isocyanurate (Aldrich) in 95.5 g propyl acetate, then filtering the solution through a 0.45µm Teflon^{®} PTFE membrane filter. A 2"x3" borosilicate glass slide was cleaned by rinsing with a stream of iso-propyl alcohol followed by blowing dry air. The cleaned slide was treated with a solution of 5 wt% acryloxypropyltrimethoxy silane (APTMS, Aldrich) in 95% ethanol, which was applied by first swabbing with a cotton tipped applicator then baking the so-applied film 10 min @ 100°C in a circulating air oven then removed and cooled to ambient temperature. The slide was rinsed again with iso-propyl alcohol and air dried. The so-treated glass slide was coated with formulation **A** by immersing it vertically in formulation **A** to a depth of approximately 60 mm, allowing it to remain immersed undisturbed for 30 sec, then withdrawing it vertically at a constant rate of 25 mm/min. After withdrawal from formulation **A,** the coated slide was allowed to dry at ambient temperature in the air for <15 min. The dried, coated slide was placed under a nitrogen atmosphere for 3 min at ambient temperature then heated under a nitrogen atmosphere 20 min at 120°C. After this treatment the thin fluorocarbon film deposited on the glass slide was transparent and completely insoluble in organic solvents. Comparison of the transmission spectrum of this sample and that of an uncoated borosilicate glass slide gave a ΔTₛₒₗ = 1.7% for each glass surface. The thickness of the fluoroelastomer coating was estimated to be ~96 nm.

### Comparative Example 2.

2"x2" borosilicate glass slides were laminated between two 0.004" thick films of Surlyn^{®} 1857 using a hot hydrostatic press. To stop the sample from sticking to the surface of the press, release coversheets (e.g. Teflon^{®} FEP films) were added above and below the sample stack prior to insertion into the hot press. After evacuating the sample to remove trapped air, the press was brought to 150°C and 2,500 psi pressure and allowed to set for 15 min. Thereafter, the sample is removed from the press and allowed to cool to room temperature. After removing the two coversheets, the slides were coated by immersing them vertically in a 4.5 weight % solution of Viton^{®} GF-200S fluoroelastomer (DuPont) in propyl acetate to a depth of approximately 60 mm, allowing them to remain immersed undisturbed for 30 sec, then withdrawing them vertically at a constant rate. After withdrawal from the solution, the coated slides were allowed to dry at ambient temperature in the air. Comparison of the transmission spectrum of this sample and that of an uncoated borosilicate glass slide gave a ΔTₛₒₗ = 2.3% for each glass surface. The thickness of the fluoroelastomer coating was estimated to be -88 nm.

### Comparative Example 3.

Electronic displays utilize various commercially available anitireflective films to reduce specularly reflected "ghost images" and improve the visual appeal and sharpness of displayed images. These commercial antireflective films are generally glued to the surface of the glass with a pressure sensitive adhesive. While these antireflective films do reduce reflection, they often don't provide that necessary increase in transmission that would allow them to be used on photovoltaic panels. This is because displays have a narrower bandwidth requirement limited to visible wavelengths (400nm-700nm) than photovoltaic modules (380nm-1200nm), and a less stringent requirement in overall light transmission.

To illustrate that these commercial antireflective films are not suitable for light capturing in photovoltaic applications, we substituted our light capturing film in Comparative Example 1 with a commercial antireflecive film commonly used for electronic displays. Two 2"x2" sheets of antireflective film (Vikuiti^{®} MP-200, manufactured by the 3M company, St. Paul, Minnesota) were bonded to the two sides of a 2"x2" solar grade float glass (Krystal Klear^{®} glass from AFG Industries, Kingsport, Tennessee) at room temperature with a pressure sensitive adhesive. Diffused optical transmission spectrum was obtained between 250-1300nm, and compared to that of bare Krystal Klear^{®} glass. A net loss in light transmission corresponding to a of ΔTₛₒₗ = -1.5% was observed. This indicates that antireflective films commonly used in electronic displays do not neccessarily produce light gain to improve conversion efficiency in photovoltaic modules.

### Example 1:

Formulation **B** was prepared by dissolving 2 g Viton® GF-200S fluoroelastomer (DuPont), 0.2 g Irgacure^{®}-651 (Ciba Specialty Chemicals) and 0.2 g triallyl isocyanurate (Aldrich) in 32 g propyl acetate, then filtering the solution through a 0.45µm Teflon^{®} PTFE membrane filter. Formulation B was coated onto a 4.5" wide x 36" long film of Surlyn^{®} 1705-1 (thickness ~0.003") using a Yasui-Seiki Co. Ltd., Tokyo, Japan, micro-gravure coating apparatus as described in U.S. Pat. No. 4,791,881. The apparatus includes a doctor blade and a Yasui-Seiki Co. gravure roll #230 (230 lines/inch, 1.5 to 3.5 µm wet thickness range) having a roll diameter of 20 mm. Coating was carried out using a gravure roll revolution of 6.0 rpm and a transporting line speed of 0.5 m/min., with the roller rotating in the opposite direction to the film line. The coated film was cured immediately after coating. 4.5"x4.5" squares of film were cut and placed under a nitrogen atmosphere. They were heated at 60°C under a nitrogen atmosphere while being irradiated with a Black-Ray^{®} longwave ultraviolet lamp model B100 AP (UVP Co. Upland, CA) for 5 minutes. The lamp was placed two inches from the center of the coated film, and the lamp intensity at this distance was 22 mWatt/cm² at 365 nm. The film samples were laminated onto glass in the game manner as described in Comparative Example 2. 2"x2" borosilicate glass slide was placed between two coated film samples above. The laminate is then sandwiched between two release coversheets (e.g. Teflon^{®} FEP film) and inserted into the hot press. After evacuating the sample to remove trapped air, the press is brought to 150°C and 2,500 psi pressure and allowed to set for 15 minutes. Metal shims with slightly thinner the total thickness of the lamination stacks were use used to prevent the press from stress-cracking the glass slide. Thereafter, the sample is then removed from the press and allowed to cool to room temperature. After removing the coversheets, diffused transmission and reflection spectra were taken. Comparison of the transmission spectrum of these laminated samples with that of bare glass gave a ΔTₛₒₗ = 1.7% for each glass surface. The thickness of the fluoroelastomer coating was estimated to be ~ 103 nm.

### Example 2:

Solution of Formulation **B** was used to coat a 4.5" wide x 36" long film of a UV-stabilized Surlyn^{®}-9120 (thickness ~0.003") using the micro-gravure coating apparatus as described in Example 1. After curing the coating with ultraviolet light under nitrogen, the films were laminated to both sides of several 2"x2" Krystal Klear^{®} float glass. Four different lamination temperature-pressure combinations were used as summarized in Table I. Diffused % transmission and % reflection spectra were obtained for these laminates, and the light gains (ΔTₛₒₗ) measured were included in Table I.

**Table I. Light gain obtained from AR laminates processed at various temperatures and pressures.**

| Sample ID | Sample/Lamination Conditions | Δ Tsol |
|---|---|---|
| AA | MP-200/Krystal Klear^{®} Glass | -1.5 |
| Control | Bare Krystal Klear^{®} Glass | 0.0 |
| BB | Laminated at 250C & 2000 psi | 1.7 |
| CC | Laminated at 250C & 0 psi | 1.5 |
| DD | Laminated at 200C & 2000 psi | 1.7 |
| EE | Liminated at 200C & 0 psi | 1.4 |

### Example 3.

To 103.2g of solution of Formulation **B** described in Example 1, 30 mg of Tinuvin^{®} 405 was added to create homogeneous solution of Formulation **C**. This solution was use to coat a 4.5" wide x 36" long film of a Surlyn^{®}-9120 (thickness ~0.003") using the micro-gravure coating apparatus as described in Example 1. After curing the coating for 15 minutes under a Black-Ray ultraviolet lamp, the films were laminated to both sides of a 2"x2" Krystal Klear^{®} float glass. The lamination conditions were the same as described in Comparative Example 2 except that one of the two release films was replaced by an FEP coated mat weaved from fiber glass yarns. The bumpy surface of the glass matt creates sufficient pressure differences on the molten Surlyn^{®} and cause it to flow locally, resulting in a matted surface. Diffused % transmission and % reflection spectra were taken with the matted surface facing the light source of the spectrophotometer. An optical light gain of ΔTₛₒₗ ~ 1.9% was measured for the matted surface. A pronounced antiglare effect was also observed for this surface.

### Example 4

Formulation **A** was prepared by dissolving 4.5 g Viton^{®} GF-200S fluoroelastomer (DuPont), 0.45 g benzoyl peroxide (Aldrich) and 0.45 g triallyl isocyanurate (Aldrich) in 95.5 g propyl acetate, then filtering the solution through a 0.45µm Teflon^{®} PTFE membrane filter. 2"x2" pieces of Surlyn^{®} 1857 3.0 mil-thick films were calendered between pieces of Teflon^{®} FEP and Teflon^{®} PFA films in the following arrangement: FEP / Surlyn^{®}/PFA / Surlyn^{®}/FEP. The adhesion of Surlyn^{®} to FEP was stronger than to PFA and the Surlyn^{®}/FEP laminate could be easily separated from the PFA film. The Surlyn^{®}/FEP laminates were coated with formulation A by immersing the sample vertically into formulation **A,** allowing it to remain immersed undisturbed for 30 seconds, then withdrawing it vertically at a constant rate of 25 mm/min. After withdrawal from formulation **A,** the coated samples were allowed to dry at ambient temperature in air. The coating formulation **A** described above was used but the samples were not cured. After drying the samples, the Surlyn^{®} films were separated from the FEP films yielding samples of Surlyn^{®} coated on one side with formulation A. The film samples were laminated onto glass in the same manner as described in Example 1. Comparison of the diffused transmission spectrum of these laminated samples with bare glass gave a ΔTₛₒₗ = -0.45% for each glass surface.

### Example 5:

A uniform 27.5 mm x 38 mm multi-crystalline solar cell was placed on top of a 5 cm x 5 cm x 4-mil thick brass sheet. Two thin stripes (~4 cm x 1 cm wide) of Surlyn^{®}-9120 film were placed side-by-side on top of the solar cell. One of these Surlyn^{®} films also carried an AR-coating the preparation of which was detailed in Example 1. A protective polyester cover sheet was placed over the whole stack and then placed into a vacuum press and heated to ~150C for 15 minutes. After peeling off the protective cover sheet, a partially encapsulated solar cell structure resulted. A mask (with an opening measuring ~2.75 cm x 0.5 cm) was placed over the cell area encapsulated by the uncoated Surlyn^{®} stripe. The assembly was then placed under a solar simulator (Oriel instrument, Model # 81150, Stratford, Connecticut, USA) operating at an intensity of ~20 mW/cm². The electrical output of the solar cell was connected to a standard current-voltage scanner, and the resulting current and voltage characteristics recorded. A light-to-electricity conversion efficiency of 6.15% was observed, with a short-circuit current density of 6.64 mA/cm². The mask was then moved and placed over the cell area encapsulated by the AR-coated Surlyn^{®} stripe, and the current-voltage was scanned. A conversion efficiency of 6.36% was recorded, with the associated short-circuit current density of 6.86 mA/cm². The increases due to the presence of the AR-coating are thus ~3.4% and 3.31% respectively. This example illustrates that the light capturing laminate can be applied directly onto the solar cell surface instead of onto the glass surface.

## Claims

1. A process comprising
a) providing a substrate comprising a front surface and a back surface;
b) laminating on the front surface a film comprising at least one cross-linked fluoropolymer layer or layers wherein the fluoropolymer layer or layers have a thickness between 75 and 150 nanometers and the fluoropolymer layer or layers are positioned on a carrier comprising ethylene copolymer such that the carrier is in contact with the substrate; and
b) attaching at least one solar cell to the back surface of the substrate.

2. The process of Claim 1 wherein the fluoropolymer is cross-linked.

3. The process of Claim 1 wherein the ethylene copolymer is Surlyn^{®} or Elvax^{®}.

4. The process of Claim 1 wherein the substrate and the at least one solar cell are an existing solar module.

5. The process of Claim 1 wherein the fluoropolymer and the ethylene copolymer comprise a stabilizer package.

6. The process of Claim 1 wherein the ethylene copolymer is textured prior to laminating.

7. The process of Claim 1 wherein the substrate is flexible.

8. A device comprising:
a) a mounting layer comprising:
i) a substrate comprising a front surface and a back surface;
ii) a film laminated to the front surface of the substrate wherein the film comprises at least one cross-linked fluoropolymer layer or layers having a thickness between 75 and 150 nanometers positioned on a carrier comprising ethylene copolymer such that the carrier is in contact with the substrate; and
b) at least one solar cell attached to the back surface of the substrate.

9. A device comprising:
a) at least one solar cell comprising a front surface;
b) a film laminated to the front surface of the solar cell wherein the film comprises at least one cross-linked fluoropolymer layer or layers having a thickness between 75 and 150 nanometers positioned on a carrier comprising ethylene copolymer such that the carrier is in contact with the solar cell.
